# EUROPEAN PATENT APPLICATION

(11) **EP 4 815 692 A1**
(43) Date of publication of application: **30.09.2026**
(21) Application number: 24894559.4
(22) Date of filing: 19.11.2024
(51) Int. Cl.: H10K 59/121, H10K 59/35, H10K 59/80

(54) **ORGANIC LIGHT-EMITTING DISPLAY DEVICE**

(30) Priority: 20.11.2023 KR 20230160690; 18.11.2024 KR 20240164341
(71) Applicant: Yas Co., Ltd., Paju-si, Gyeonggi-do 10857 (KR); Ahn, Byungchul, Seoul 06574 (KR)
(72) Inventor: AHN, Byungchul, Seoul 06574 (KR)
(74) Representative: Epping - Hermann - Fischer
(86) International application number: PCT/KR2024/018218
(87) International publication number: WO 2025/110667

(57) **Abstract**

The organic light-emitting display device may include a plurality of pixels on a substrate. The plurality of pixels may include a first subpixel, a second subpixel, and a third subpixel having a three-dimensional structure. The second subpixel may be disposed to overlap horizontally with the first subpixel, and the third subpixel may be disposed to overlap vertically with the first subpixel and the second subpixel. The first subpixel may include a first organic light-emitting element, the second subpixel may include a second organic light-emitting element, and the third subpixel may include a third organic light-emitting element.

## Description

### BACKGROUND

### Field of the Disclosure

The embodiment relates to an organic light-emitting display device.

### Discussion of the Related Art

Recently, as society has entered the full-fledged information age, interest in information displays that process and display large amounts of information has been increasing. In addition, the display field is developing rapidly due to the increasing demand for portable information media. In response to these, various lightweight and thin flat panel display devices have been in the spotlight.

Among these flat panel display devices, an organic light-emitting display device (hereinafter referred to as OLED) has been in the spotlight. The OLED is being actively developed for use as a display device for a head-mounted display (HMD) that is mounted close to the human eye. The HMD is worn in the form of a helmet or glasses, and virtual reality (VR) or augmented reality (AR) may be implemented.

The HMD is equipped with a high-resolution small OLED. The high-resolution small OLEDs are disposed with organic light-emitting elements on driving circuits formed using a wafer-based semiconductor process. Meanwhile, a glasses-type HMD requires brighter and clearer screens in a very small size of screen. To this end, the amount of light from the organic light-emitting element and the light extraction efficiency thereof must be maximized. In addition, light leakage, etc., between pixels P must be suppressed to improve image quality. The technology to improve light extraction efficiency applicable to ultra-high resolution is expected to be widely applied to a large-screen display industry such as a mobile device and an IT device.

Meanwhile, a fine metal mask (FMM) is used as a deposition pattern mask to deposit an organic light-emitting layer constituting an organic light-emitting element by subpixel.

However, it is quite difficult to form an organic light-emitting layer by subpixel using an FMM when manufacturing a high-definition (e.g., 500 PPI or higher) display device or a large-area (e.g., 8^{th} generation or higher) display device. In addition, there is a limit to further increasing the high-definition when using an FMM. In addition, there are problems in that the yield is reduced and the manufacturing cost increases when using an FMM. In addition, when using FMM, there is a problem with decreased product lifespan because the optimization of deposition is difficult.

Meanwhile, as the resolution of the display has recently increased, the pixel resolution (ppi) has also increased, and the gap between pixels (or subpixels) has become narrower. In addition, as an efficiency of the light-emitting material for the organic light-emitting element has increased, it has the advantage of being able to produce high luminance with low current and voltage, which reduces power consumption.

However, there is still a problem of low lifetime luminous efficacy in a display with high resolution. Here, the lifetime luminous efficacy may be defined as the lifetime ratio or brightness to the emission area ratio. For example, in terms of the product, when the emission area ratio increases, brightness may increase for the same lifetime, or lifetime may increase for the same brightness, or both lifetime and brightness may increase.

### SUMMARY

An object of the embodiment is to solve the foregoing and other problems.

Another object of the embodiments is to provide a high-definition and high-resolution organic light-emitting display device.

Another object of the embodiments is to provide an organic light-emitting display device that does not use FMM.

Another object of the embodiment is to provide an organic light-emitting display device capable of improving image quality.

The technical problems of the embodiments are not limited to those described in this item and comprise those that may be understood through the description of the invention.

According to one aspect of the embodiment, in order to achieve the above or other objects, an organic light-emitting display device, comprising: a plurality of pixels on a substrate, wherein the plurality of pixels each comprise a first subpixel, a second subpixel, and a third subpixel having a three-dimensional structure, wherein the second subpixel is disposed to overlap horizontally with the first subpixel, the third subpixel is disposed to overlap vertically with the first subpixel and the second subpixel, and wherein the first subpixel comprises a first organic light-emitting element, the second subpixel comprises a second organic light-emitting element, and the third subpixel comprises a third organic light-emitting element.

The pixel may have a same size as a size of the third subpixel.

The pixel may have a same size as a sum of a size of the first subpixel and a size of the second subpixel.

The second organic light-emitting element may be disposed to overlap horizontally with the first organic light-emitting element, and the third organic light-emitting element may be disposed to overlap vertically with the first organic light-emitting element and the second organic light-emitting element.

The first organic light-emitting element, the second organic light-emitting element, and the third organic light-emitting element may each comprise an anode electrode, an organic light-emitting layer, and a cathode electrode, and the anode electrode may be independently disposed in the first subpixel, the second subpixel, and the third subpixel, and the cathode electrode may be commonly disposed in the first subpixel and the second subpixel.

The first subpixel, the second subpixel, and the third subpixel may each comprise an emission region and a non-emission region, and the emission region may have a size corresponding to the anode electrode.

A third anode electrode of the third organic light-emitting element may vertically overlap a first anode electrode of the first organic light-emitting element and a second anode electrode of the second organic light-emitting element.

A third anode electrode of the third organic light-emitting element may have a size greater than a size of a first anode electrode of the first organic light-emitting element or a size of a second anode electrode of the second organic light-emitting element.

The third subpixel is disposed in the first subpixel and the second subpixel.

A first anode electrode of the first organic light-emitting element and a second anode electrode of the second organic light-emitting element may each comprise a reflective metal, a first cathode electrode of the first organic light-emitting element and a second cathode electrode of the second organic light-emitting element may each comprise a transparent or translucent conductive film. A third anode electrode of the third organic light-emitting element may comprise a transparent conductive film, and a third cathode electrode of the third organic light-emitting element may comprise a transparent or translucent conductive film.

The third subpixel is disposed under the first subpixel and the second subpixel.

A third anode electrode of the third organic light-emitting element may comprise a reflective metal, and a third cathode electrode of the third organic light-emitting element may comprise a transparent or translucent conductive film. A first anode electrode of the first organic light-emitting element and a second anode electrode of the second organic light-emitting element each comprise a transparent conductive film.

A first cathode electrode of the first organic light-emitting element and a second cathode electrode of the second organic light-emitting element may each comprise a transparent or translucent conductive film.

The organic light-emitting display device may further comprise a plurality of insulating layers between the first organic light-emitting element and the third organic light-emitting element and between the second organic light-emitting element, and the third organic light-emitting element. The plurality of insulating layers may each comprise at least one or more organic insulating layer and at least one or more inorganic insulating layer.

A lowermost layer and an uppermost layer among the plurality of insulating layers may be inorganic insulating layers.

The organic light-emitting display device may further comprise a plurality of first banks between the plurality of first subpixels and the plurality of second subpixels; and a plurality of second banks between the plurality of third subpixels.

A second distance between the plurality of second banks may be greater than a first distance between the plurality of first banks.

A second distance between the plurality of second banks may be equal to a width of the pixel or a width of the third subpixel.

One of the first organic light-emitting element and the second organic light-emitting element may comprise a red organic light-emitting element and the other comprises a green organic light-emitting element, and the third organic light-emitting element comprises a blue organic light-emitting element.

The effect of the organic light-emitting display device according to the embodiment is described as follows.

According to at least one of the embodiments, there is an advantage that a first subpixel, a second subpixel, and a third subpixel may be disposed three-dimensionally to form a pixel, so that a size of a pixel become smaller and smaller, thereby enabling a high-definition and ultra-high-resolution display to be implemented.

According to at least one of the embodiments, the first subpixel, the second subpixel, and the third subpixel constituting the pixel may be disposed three-dimensionally, so that a size of a blue subpixel increases to the size of the pixel, thereby greatly increasing the emission region and improving the lifetime luminous efficacy.

According to at least one of the embodiments, since the organic light-emitting material constituting a third organic light-emitting layer is deposited on the entire region of the substrate, there is an advantage in that the process freedom can be increased and the yield can be improved because there is no need to use a separate mask.

According to at least one of the embodiments, there is an advantage that the first subpixel, the second subpixel, and the third subpixel may be disposed three-dimensionally to form the pixel, and the anode electrode and the cathode electrode of each of the first organic light-emitting element, the second organic light-emitting element, and the third organic light-emitting element are configured as a reflective electrode, a transparent or translucent conductive film, etc., so that recycling of a first color light, a second color light, and a third color light can be improved between these electrodes, thereby improving the light extraction efficiency.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### BRIEF DESCRIPTION OF THE DRAWINGS

FIG. 1 is a plan view illustrating an organic light-emitting display device according to an embodiment.
FIG. 2 is a cross-sectional view illustrating an organic light-emitting display device according to the first embodiment.
FIGS. 3A and 3B illustrate a cathode electrode of each organic light-emitting element connected to a power line.
FIG. 4 is a cross-sectional view illustrating an organic light-emitting display device according to a second embodiment.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### DETAILED DESCRIPTION

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

The following description is limited to a top-emission type display, but the embodiment may also be applied to a bottom-emission type display. A top-emission type organic light-emitting display device may display an image by emitting light in an upward direction, i.e., toward the front side. A bottom-emission type organic light-emitting display device may display an image by emitting light in a downward direction, i.e., toward the rear side.

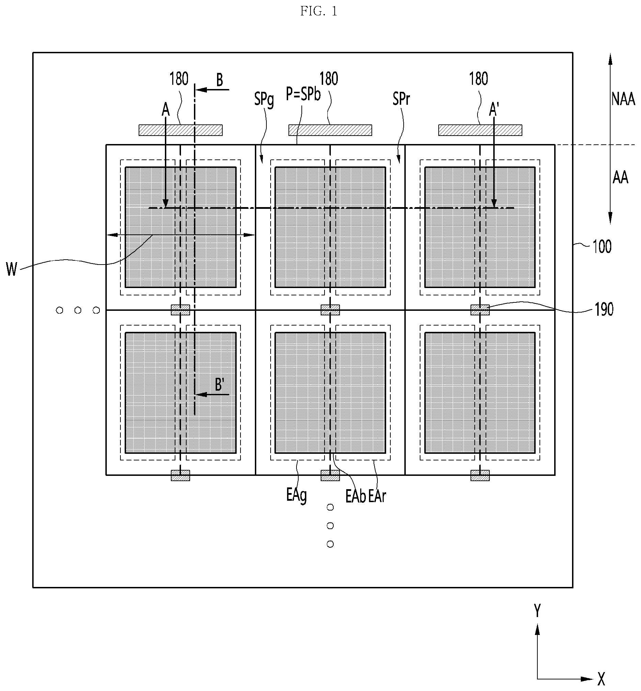

FIG. 1 is a plan view illustrating an organic light-emitting display device according to an embodiment.

Referring to FIG. 1, an organic light-emitting display device according to an embodiment may comprise a plurality of pixels P arranged on a substrate 100.

The substrate 100 may comprise a display region AA and a non-display region NAA surrounding the display region AA. A plurality of pixels P may be disposed on the display region AA. A driving device such as a gate driver, a data driver, etc. may be disposed in the non-display region NAA, but is not limited thereto. The plurality of pixels P may be arranged along a first direction X. The plurality of pixels P may be arranged along a second direction Y. The plurality of pixels P may be arranged in a matrix. The first direction X may be a horizontal direction or a lateral direction, and the second direction Y may be a vertical direction or a longitudinal direction.

Each pixel P may comprise a plurality of subpixels SPr, SPg, and SPb. Each pixel P may comprise subpixels SPr, SPg, and SPb of at least three different colors. Although not illustrated, the pixel P may further comprise a colorless transparent region to implement a transparent display.

Each pixel P may comprise a first subpixel SPr, a second subpixel SPg, and a third subpixel SPb. In this instance, the first subpixel SPr may be a red subpixel, the second subpixel SPg may be a green subpixel, and the third subpixel SPb may be a blue subpixel.

As a first example, the plurality of subpixels SPr, SPg, and SPb may be separated into one or more pixel P units or row-line units along the second direction Y. For example, the first subpixels SPr may be separated into one or more pixel P units or row-line units along the second direction Y, the second subpixels SPg may be separated into one or more pixel P units or row-line units along the second direction Y, and the third subpixels SPb may be separated into one or more pixel P units or row-line units along the second direction Y.

As a second example, the plurality of subpixels SPr, SPg, and SPb may be arranged in a stripe shape along the second direction Y. In the stripe shape structure, the plurality of subpixels SPr, SPg, and SPb may be arranged continuously without being separated along the second direction Y, respectively. For example, the second subpixel SPg may be arranged continuously along the second direction Y, the first subpixel SPr may be arranged continuously along the second direction Y, and the third subpixel SPb may be arranged continuously along the second direction Y.

Meanwhile, in the first and second examples, the second subpixel SPg, the first subpixel SPr, and the third subpixel SPb may be arranged alternately in a column-line unit along the first direction X. That is, in the embodiment, the second subpixel SPg, the first subpixel SPr, and the third subpixel SPb having different colors may be disposed in a side-by-side structure along the first direction X. In the side-by-side structure, it is very important to implement high definition and high resolution without reducing an emission area of each of the plurality of subpixels SPr, SPg, and SPb.

Meanwhile, as illustrated in FIG. 1, in the embodiment, the plurality of pixels P may comprise the first subpixel SPr, the second subpixel SPg, and the third subpixel SPb having a three-dimensional structure. That is, the first subpixel SPr, the second subpixel SPg, and the third subpixel SPb may be disposed three-dimensionally, thereby configuring the pixel P. That is, the first subpixel SPr, the second subpixel SPg, and the third subpixel SPb may be disposed not only horizontally but also vertically relative to each other, thereby configuring the pixel P.

For example, the sum of a size (or area) of the first subpixel SPr and a size (or area) of the second subpixel SPg may be equal to a size (or area) of the pixel P. For example, the sum of a width of the first subpixel SPr and a width of the second subpixel SPg may be equal to a width W of the pixel P.

For example, a size (or area) of the third subpixel SPb may be equal to the size (or area) of the pixel P. For example, a width of the third subpixel SPb may be equal to the width W of the pixel P.

In this instance, the first subpixel SPr, the second subpixel SPg, and the third subpixel SPb may be disposed three-dimensionally so that the pixel P may comprise all of the first subpixel SPr, the second subpixel SPg, and the third subpixel SPb. To this end, the second subpixel SPg may be disposed to overlap horizontally with the first subpixel SPr, and the third subpixel SPb may be disposed to overlap vertically with the first subpixel SPr and the second subpixel SPg.

The plurality of first subpixels SPr and the plurality of second subpixels SPg may be disposed alternately along the first direction X. The plurality of third subpixels SPb may be disposed in units of pixels P along the first direction X.

The first subpixel SPr may emit first color light, the second subpixel SPg may emit second color light, and the third subpixel SPb may emit third color light. Accordingly, a full color image may be displayed for each unit pixel P by the first color light, the second color light, and the third color light. For example, the first color light may be red light, the second color light may be green light, and the third color light may be blue light, but is not limited thereto.

According to an embodiment, the first subpixel SPr, the second subpixel SPg, and the third subpixel SPb may be disposed three-dimensionally to form the pixel P, so that the size of the pixel P can be further reduced, thereby enabling a high-definition and ultra-high-resolution display to be implemented.

Meanwhile, as illustrated in FIG. 1, the first subpixel SPr, each of the second subpixel SPg, and the third subpixel SPb may comprise an emission region EAr, EAg, and EAb, and a non-emission region. The emission region EAr, EAg, and EAb is a region from which corresponding color light is emitted, and the wider the emission region EAr, EAg, and EAb, the higher the lifetime luminous efficiency. The non-emission region may be a remaining region excluding the emission region EAr, EAg, and EAb in each of the first subpixel SPr, the second subpixel SPg, and the third subpixel SPb.

As illustrated in FIG. 1, the third emission region EAb of the third subpixel SPb may be disposed to vertically overlap the first emission region EAr of the first subpixel SPr. The third emission region EAb of the third subpixel SPb may be vertically overlapped with the second emission region EAg of the second subpixel SPg. The first emission region EAr of the first subpixel SPr and the second emission region EAg of the second subpixel SPg may not vertically overlap with each other. That is, the first emission region EAr of the first subpixel SPr and the second emission region EAg of the second subpixel SPg may be disposed to horizontally overlap.

A size of the third emission region EAb of the third subpixel SPb may be greater than a size of the first emission region EAr of the first subpixel SPr. The size of the third emission region EAb of the third subpixel SPb may be greater than a size of the second emission region EAg of the second subpixel SPg. Although the size of the first emission region EAr and the size of the second emission region EAg are illustrated as being the same in the drawing, they may be different from each other.

According to an embodiment, the size of the third emission region EAb of the third subpixel SPb can be increased to the size of the pixel P, so that the third emission region EAb can be greatly increased, and thus the lifetime light-emitting ratio can be improved.

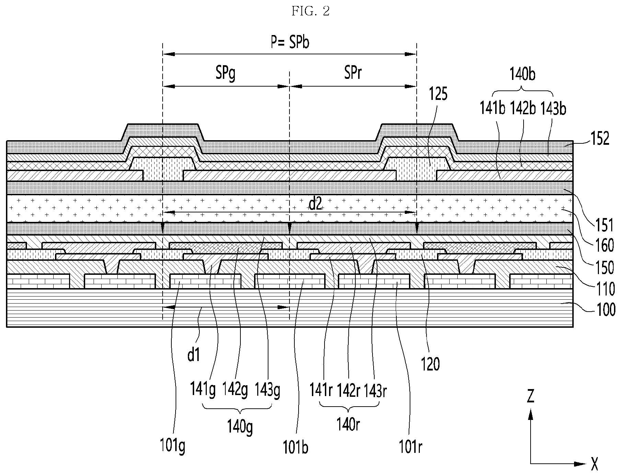

FIG. 2 is a cross-sectional view illustrating an organic light-emitting display device according to the first embodiment. FIG. 2 is a cross-sectional view taken along line A-A' of the organic light-emitting display device of FIG. 1.

Referring to FIG. 1 and FIG. 2, the organic light-emitting display device may comprise a substrate 100, a plurality of driving circuits 101r, 101g and 101b, a protective layer 110, a plurality of banks 120 and 125, a plurality of organic light-emitting elements 140r, 140g and 140b, a plurality of insulating layers 150 to 152 and 160, etc.

A plurality of pixels P may be disposed on the substrate 100. The plurality of pixels P may each comprise a first subpixel SPr, a second subpixel SPg, and a third subpixel SPb having a three-dimensional structure.

As described above, in order to implement a high-definition and ultra-high-resolution display, the first subpixel SPr, the second subpixel SPg, and the third subpixel SPb may be disposed three-dimensionally. The third subpixel SPb may be disposed in the first subpixel SPr and may vertically overlap with the first subpixel SPr. The third subpixel SPb may be disposed on the second subpixel SPg and may vertically overlap with the second subpixel SPg.

The plurality of driving circuits 101r, 101g, and 101b may be disposed on a substrate 100, and the protective layer 110 may be disposed on the plurality of driving circuits 101r, 101g, and 101b.

The substrate 100 may be a substrate having characteristics such as rigid, flexible, foldable, and rollable. The substrate 100 may be made of a silicon wafer, glass, plastic, ceramic, etc. The substrate 100 may be made of a transparent material or an opaque material.

The plurality of driving circuits 101r, 101g, and 101b may comprise a first driving circuit 101r, a second driving circuit 101g, and a third driving circuit 101b. The first driving circuit 101r may be connected to the first subpixel SPr and may drive the first subpixel SPr to emit a first color light. The second driving circuit 101g may be connected to the second subpixel SPg and may drive the second subpixel SPg to emit a second color light. The third driving circuit 101b may be connected to the third subpixel SPb and may drive the third subpixel SPb to emit a third color light.

Each driving circuit 101r, 101g, and 101b may comprise a plurality of transistors and at least one or more capacitor. One of the plurality of transistors may be a driving transistor.

The protection layer 110 may be disposed on the plurality of driving circuits 101r, 101g, and 101b to protect the plurality of driving circuits 101r, 101g, and 101b. The protective layer 110 may be a planarization layer for stably forming layers thereon.

The protective layer 110 may be a single layer formed of an inorganic film or an organic film. The protective layer 110 may be multiple layers of inorganic films, or a combination of multiple layers of inorganic films and multiple layers of organic films. The protective layer 110 may be formed of a silicon oxide film (SiOx), a silicon nitride film (SiNx), or multiple films thereof.

For example, the protective layer 110 may be composed of a multiple structure of an organic film and an inorganic film. In this instance, the organic film may comprise an acrylic resin, an epoxy resin, a phenolic resin, a polyamide resin, a polyimide resin, etc. The inorganic film may comprise a silicon oxide film (SiOx), a silicon nitride film (SiNx), etc.

The plurality of banks 120 and 125 may comprise a plurality of first banks 120, a plurality of second banks 125, etc. The plurality of first banks 120 may be disposed on the protective layer 110 between the plurality of first subpixels SPr and the plurality of second subpixels SPg. The plurality of second banks 125 may be disposed on the second inorganic insulating layer 151, which is the uppermost layer among the plurality of insulating layers 150, 160, and 151, between the plurality of third subpixels SPb. The first bank 120 may serve to separate the first subpixel SPr and the second subpixel SPg, and the second bank 125 may serve to separate the adjacent third subpixels SPb.

In the drawing, the thickness, size, shape, etc. of the first bank 120 and the second bank 125 are depicted differently from each other, and the thickness, size, shape, etc. may be changed.

The first bank 120 and/or the second bank 125 may comprise an inorganic material or an organic material. For example, the first bank 120 and/or the second bank 125 may comprise an inorganic material such as SiNx, SiON, etc.

Some of the plurality of first banks 120 may vertically overlap with the second bank 125, but the other banks may not vertically overlap with the second bank 125.

This may be due to a first distance d1 between the plurality of first banks 120 and a second distance d2 between the plurality of second banks 125 being different. As illustrated in FIG. 2, the second distance d2 between the plurality of second banks 125 may be greater than the first distance d1 between the plurality of first banks 120. In addition, as illustrated in FIGS. 1 and 2, the second distance d2 between the plurality of second banks 125 may be equal to the width W of the pixel P or the width of the third subpixel SPb.

Meanwhile, the plurality of organic light-emitting elements 140r, 140g, and 140b may comprise a first organic light-emitting element 140r, a second organic light-emitting element 140g, and a third organic light-emitting element 140b.

The first organic light-emitting element 140r may be disposed in the first subpixel SPr, the second organic light-emitting element 140g may be disposed in the second subpixel SPg, and the third organic light-emitting element 140b may be disposed in the third subpixel SPb.

As described above, since the first subpixel SPr, the second subpixel SPg, and the third subpixel SPb are disposed three-dimensionally, the first organic light-emitting element 140r, the second organic light-emitting element 140g, and the third organic light-emitting element 140b may also be disposed three-dimensionally.

The third organic light-emitting element 140b may be disposed on an upper side of the first organic light-emitting element 140r. The third organic light-emitting element 140b may be disposed on an upper side of the second organic light-emitting element 140g.

The second organic light-emitting element 140g may be disposed to overlap horizontally with the first organic light-emitting element 140r. The third organic light-emitting element 140b may be disposed to overlap vertically with the first organic light-emitting element 140r and the second organic light-emitting element 140g.

The first organic light-emitting element 140r and the second organic light-emitting element 140g may be disposed on the protective layer 110, and the third organic light-emitting element 140b may be disposed on the second inorganic insulating layer 151.

One of the first organic light-emitting element 140r and the second organic light-emitting element 140g may comprise a red organic light-emitting element, and the other may comprise a green organic light-emitting element. The third organic light-emitting element 140b may comprise a blue organic light-emitting element.

In a top-emission type manner, the first color light, the second color light, and the third color light generated from the first organic light-emitting element 140r, the second organic light-emitting element 140g, and the third organic light-emitting element 140b, respectively, may be emitted toward the front side through the third inorganic insulating layer 152. For example, the first color light may be red light, the second color light may be green light, and the third color light may be blue light, but is not limited thereto.

In the bottom-emission type manner, the first color light, the second color light, and the third color light generated from the first organic light-emitting element 140r, the second organic light-emitting element 140g, and the third organic light-emitting element 140b, respectively, may be emitted toward the rear side through the substrate 100.

Meanwhile, the first organic light-emitting element 140r may comprise a first anode electrode 141r, a first organic light-emitting layer 142r, a first cathode electrode 143r, etc. The second organic light-emitting element 140g may comprise a second anode electrode 141g, a second organic light-emitting layer 142g, a second cathode electrode 143g, etc. The third organic light-emitting element 140b may comprise a third anode electrode 141b, a third organic light-emitting layer 142b, a third cathode electrode 143b, etc. The first organic light-emitting layer 142r may generate a first color light using power between the first anode electrode 141r and the first cathode electrode 143r, the second organic light-emitting layer 142g may generate a second color light using power between the second anode electrode 141g and the second cathode electrode 143g, and the third organic light-emitting layer 142b may generate a third color light using power between the third anode electrode 141b and the third cathode electrode 143b.

The first anode electrode 141r, the second anode electrode 141g, and the third anode electrode 141b may be independently disposed in the first subpixel SPr, the second subpixel SPg, and the third subpixel SPb. That is, the first anode electrode 141r may be disposed only in the first subpixel SPr, the second anode electrode 141g may be disposed only on the second subpixel SPg, and the third anode electrode 141b may be disposed only on the third subpixel SPb.

As an example, a conductive material may be formed and patterned on the substrate 100, so that the first anode electrode 141r, the second anode electrode 141g, and the third anode electrode 141b may be independently formed in the first subpixel SPr, the second subpixel SPg, and the third subpixel SPb, respectively.

The plurality of first anode electrodes 141r and the plurality of second anode electrodes 141g may be disposed to be spaced apart from each other with the plurality of first banks 120 interposed therebetween. The plurality of third anode electrodes 141b may be disposed to be spaced apart from each other with the plurality of second banks 125 interposed therebetween.

The first anode electrode 141r may be electrically connected to the first driving circuit 101r. Since the first anode electrode 141r and the first driving circuit 101r are disposed with the protective layer 110 interposed therebetween, the first anode electrode 141r may be electrically connected to the first driving circuit 101r through the protective layer 110.

The second anode electrode 141g may be electrically connected to the second driving circuit 101g. Since the second anode electrode 141g and the second driving circuit 101g are disposed with the protective layer 110 interposed therebetween, the second anode electrode 141g may be electrically connected to the second driving circuit 101g through the protective layer 110.

The third anode electrode 141b may be electrically connected to the third driving circuit 101b through a connecting part (190 in FIG. 1). The third anode electrode 141b may be electrically connected to the third driving circuit 101b in a non-emission region between the first subpixel SPr and the second subpixel SPg or in a non-emission region between adjacent pixels P. For example, the third anode electrode 141b may be electrically connected to the third driving circuit 101b through a plurality of insulating layers 150, 160, and 151, the first bank 120, and the protective layer 110.

For example, the third driving circuit 101b may be disposed to extend from the third subpixel SPb to a region between the third subpixels SPb. For example, the third anode electrode 141b may be disposed to extend from the third subpixel SPb to a region between the third subpixels SPb. As illustrated in FIG. 1, the connecting part 190 may be disposed between the third subpixels SPb on the second direction Y. In this instance, the connecting part 190 may be disposed vertically between the extended third driving circuit 101b and the extended third anode electrode 141b. A lower side of the connecting part 190 may be electrically connected to the extended third driving circuit 101b, and an upper side of the connecting part 190 may be electrically connected to the extended third anode electrode 141b.

When the first cathode electrode 143r and the second cathode electrode 143g are disposed on the entire region of the substrate 100 as an integrated cathode electrode, when the connecting electrode between the third anode electrode 141b and the third driving circuit 101b penetrates the plurality of insulating layers 150, 160, and 151, the first bank 120, and the protective layer 110, an electrical short may occur between the connecting electrode and the first cathode electrode 143r and the second cathode electrode 143g. To prevent this problem, a through hole may be formed in the integrated cathode electrode so as to be physically spaced apart from the connecting electrode. In addition, an insulating layer may be formed between the connecting electrode and the integrated cathode electrode in the through hole of the integrated cathode electrode, but is not limited thereto.

Meanwhile, as illustrated in FIG. 1, each of the first subpixel SPr, the second subpixel SPg, and the third subpixel SPb may comprise an emission region EAr, EAg, and EAb and a non-emission region. In this instance, the first emission region EAr of the first subpixel SPr may have a size corresponding to the first anode electrode 141r. The second emission region EAg of the second subpixel SPg may have a size corresponding to the second anode electrode 141g. The third emission region EAb of the third subpixel SPb may have a size corresponding to the third anode electrode 141b.

As illustrated in FIG. 2, the third anode electrode 141b may be disposed on an upper side of the first anode electrode 141r and an upper side of the second anode electrode 141g. The third anode electrode 141b may be vertically overlapped with the first anode electrode 141r and the second anode electrode 141g.

The size of the third anode electrode 141b may be greater than the size of the first anode electrode 141r. The size of the third anode electrode 141b may be greater than the size of the second anode electrode 141g. The size of the third anode electrode 141b may be equal to or greater than the sum of the sizes of the first anode electrode 141r and the second anode electrode 141g, but is not limited thereto.

According to an embodiment, in the third subpixel SPb having the same size as the size of the pixel P, the size of the third anode electrode 141b of the third organic light-emitting element 140b may be designed to be equal to or greater than the sum of the sizes of the first anode electrode 141r and the second anode electrode 141g. Accordingly, the occupied area of the third emission region EAb of the third subpixel SPb within the pixel P can be maximized, so that the lifetime emission rate of the third color light, i.e., blue light can be increased, thereby improving the image quality.

The first organic light-emitting layer 142r and the second organic light-emitting layer 142g may be independently disposed in the first subpixel SPr and the second subpixel SPg. That is, the first organic light-emitting layer 142r may be disposed only in the first subpixel SPr, and the second organic light-emitting layer 142g may be disposed only in the second subpixel SPg.

The first organic light-emitting layer 142r may be disposed on the first anode electrode 141r in the first subpixel SPr, and the second organic light-emitting layer 142g may be disposed on the second anode electrode 141g in the second subpixel SPg. The first organic light-emitting layer 142r may be disposed on a part of an upper side of the first bank 120 positioned on each of both sides of the first subpixel SPr. The second organic light-emitting layer 142g may be disposed on a part of an upper side of the first bank 120 positioned on each of both sides of the second subpixel SPg. The first organic light-emitting layer 142r and the second organic light-emitting layer 142g may be disposed to be spaced apart from each other on the upper side of the first bank 120.

The third organic light-emitting layer 142b may be disposed on the entire region of the substrate 100, but is not limited thereto. That is, the third organic light-emitting layer 142b may be disposed not only on the third subpixel SPb but also between the third subpixel SPb. For example, the third organic light-emitting layer 142b may be disposed on a plurality of third anode electrodes 141b and a plurality of second banks 125.

According to the embodiment, since an organic light-emitting material forming the third organic light-emitting layer 142b is deposited on the entire region of the substrate 100, a separate mask does not need to be used, so that process freedom can be increased and yield can be improved.

The first cathode electrode 143r and the second cathode electrode 143g may be disposed on the substrate 100. That is, the first cathode electrode 143r and the second cathode electrode 143g may be integrally disposed on the substrate 100 without being separated from each other. For example, the first cathode electrode 143r and the second cathode electrode 143g may be commonly disposed only for the first subpixel SPr and the second subpixel SPg as an integrated cathode electrode.

Meanwhile, in an embodiment, the first anode electrode 141r and the second anode electrode 141g may comprise a reflective electrode having excellent reflection characteristics. In this instance, the first color light generated from the first organic light-emitting layer 142r and the second color light generated from the second organic light-emitting layer 142g may be reflected by the first anode electrode 141r and the second anode electrode 141g, respectively, and emitted toward the front side, so that the light extraction efficiency can be increased and the image quality can be improved.

In an embodiment, the first cathode electrode 143r and the second cathode electrode 143g may comprise a transparent or translucent conductive film.

When the first cathode electrode 143r and the second cathode electrode 143g comprise a translucent conductive film, recycling of the first color light may occur between the first anode electrode 141r and the first cathode electrode 143r and between the second anode electrode 141g and the second cathode electrode 143g, so that light extraction efficiency can be improved. That is, the first color light generated in the first organic light-emitting layer 142r may be reflected by the first cathode electrode 143r and may travel toward the rear side, and may be reflected again by the first anode electrode 141r and travel toward the front side. A part of the first color light traveled in an upper direction may transmit through the first cathode electrode 143r and be emitted toward the front side, and another part may be reflected by the first cathode electrode 143r. In this way, since the first color light is recycled between the first cathode electrode 143r and the first anode electrode 141r, more first color light may be emitted toward the front side, thereby improving light efficiency.

Similarly, since the second color light generated from the second organic light-emitting layer 142g is recycled between the second cathode electrode 143g and the second anode electrode 141g, more second color light may be emitted toward the front side, thereby improving light extraction efficiency.

In an embodiment, the third anode electrode 141b may comprise a transparent conductive film, and the third cathode electrode 143b may comprise a transparent or translucent conductive film.

When the first cathode electrode 143r, the second cathode electrode 143g, and the third cathode electrode 143b comprise transparent or translucent conductive films, recycling of third color light may occur between the third cathode electrode 143b and the first cathode electrode 143r and between the third cathode electrode 143b and the second cathode electrode 143g, so that light extraction efficiency can be improved. That is, the third color light generated in the third organic light-emitting layer 142b may be reflected by the third cathode electrode 143b and travel in a lower direction, and may be reflected again by the first cathode electrode 143r and/or the second cathode electrode 143g and travel in an upper direction. A part of the third color light traveled in the upper direction may transmit through the third cathode electrode 143b and be emitted toward the front side, and another part may be reflected by the third cathode electrode 143b. In this way, since the third color light is recycled between the third cathode electrode 143b and the first cathode electrode 143r, more third color light may be emitted toward the front side, thereby improving light efficiency.

Meanwhile, referring to FIGS. 1 and 2, a plurality of insulating layers 150 to 152 and 160 may be disposed on the substrate 100. The plurality of insulating layers 150 to 152 and 160 may comprise at least one or more inorganic insulating layer and at least one or more organic insulating layer 160. For example, the inorganic insulating layer may comprise SiNx, SiO₂, etc., but is not limited thereto.

Among the plurality of insulating layers 150, 160, and 151 disposed between the first organic light-emitting element 140r and the third organic light-emitting element 140b, the lowermost layer 150 and the uppermost layer 151 may be inorganic insulating layers. For example, the plurality of insulating layers 150, 160, and 151 may comprise, but are not limited to, a first inorganic insulating layer 150, an organic insulating layer 160, a second inorganic insulating layer 151, a third inorganic insulating layer 152, etc. At least one of the first inorganic insulating layer 150, the organic insulating layer 160, and the second inorganic insulating layer 151 may be omitted. The organic insulating layer 160 may be disposed between the first inorganic insulating layer 150 and the second inorganic insulating layer 151.

The first inorganic insulating layer 150 may be disposed on the first organic light-emitting element 140r and the second organic light-emitting element 140g. The first inorganic insulating layer 150 may be disposed on an upper side of the first cathode electrode 143r of the first organic light-emitting element 140r and an upper side of the second cathode electrode 143g of the second organic light-emitting element 140g. The first inorganic insulating layer 150 may prevent moisture, oxygen, etc. from penetrating into the first organic light-emitting layer 142r under the first cathode electrode 143r and the second organic light-emitting layer 142g under the second cathode electrode 143g.

The second inorganic insulating layer 151 may be disposed under the third organic light-emitting element 140b. The second inorganic insulating layer 151 may be disposed under the third anode electrode 141b of the third organic light-emitting element 140b. The second inorganic insulating layer 151 may prevent moisture, oxygen, etc. from penetrating into the third organic light-emitting layer 142b over the third anode electrode 141b.

Meanwhile, the third inorganic insulating layer 152 may be disposed on the third organic light-emitting element 140b. The third inorganic insulating layer 152 may be disposed on the third cathode electrode 143b of the third organic light-emitting element 140b. The third inorganic insulating layer 152 may prevent moisture, oxygen, etc. from penetrating into the third organic light-emitting layer 142b under the third cathode electrode 143b.

Using the connecting part 180 illustrated in FIG. 1, the first cathode electrode 143r of the first organic light-emitting element 140r, the second cathode electrode 143g of the second organic light-emitting element 140g, and the third cathode electrode 143b of the third organic light-emitting element 140b illustrated in FIG. 2 may be connected to a power line, which may be grounded or 0 V.

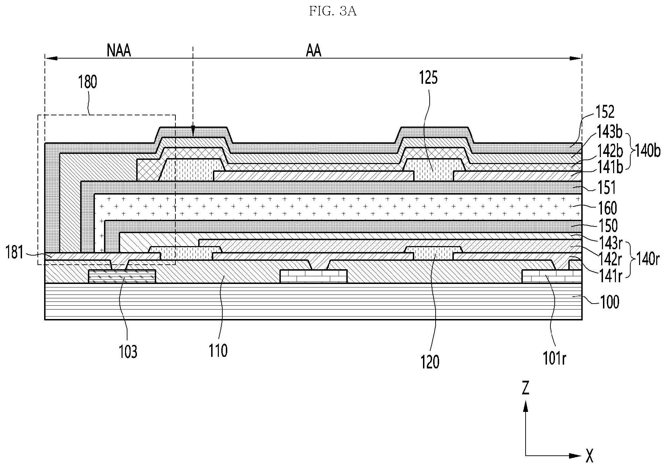

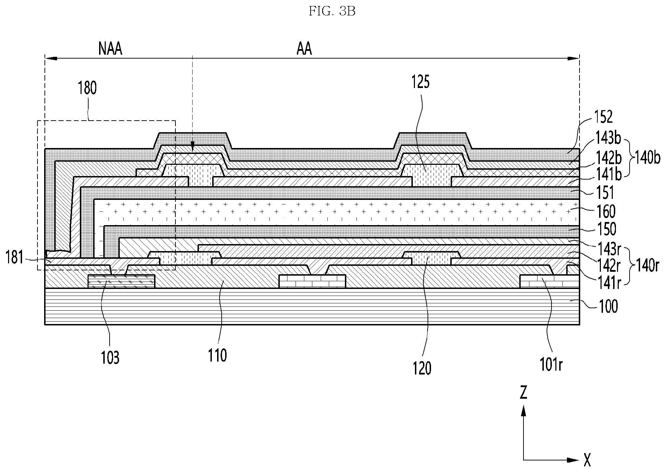

Referring to FIGS. 3A and 3B, the electrical connection between the cathode electrodes 143r, 143g, and 143b and the power line 103 will be described in detail.

FIGS. 3A and 3B illustrate a cathode electrode of each organic light-emitting element connected to a power line.

As illustrated in FIG. 3A, the cathode electrodes 143r, 143g, and 143b of the organic light-emitting elements 140r, 140g, and 140b, respectively, may be electrically connected to the power line 103 using the connecting part 180.

The connecting part 180 may be disposed in the non-display region NAA. The connecting part 180 may be disposed on the power line 103 in the non-display region NAA.

The connecting part 180 may comprise a pad electrode 181. The pad electrode 181 may be simultaneously formed using the same patterning process with the same conductive material as the first anode electrode 141r of the first organic light-emitting element 140r, but is not limited thereto. Accordingly, the pad electrode 181 may be disposed on an upper surface of the protective layer 110, similarly to the first anode electrode 141r.

The pad electrode 181 may be electrically connected to the power line 103 through the protective layer 110.

The power line 103 may be formed together with the first driving circuit 101r, for example, when forming the gate electrode, source electrode, and drain electrode of the driving transistor, but is not limited thereto.

The first cathode electrode 143r of the first organic light-emitting element 140r, the second cathode electrode 143g of the second organic light-emitting element 140g, and the third cathode electrode 143b of the third organic light-emitting element 140b may be disposed to extend to the non-display region NAA, respectively. The first cathode electrode 143r of the first organic light-emitting element 140r, the second cathode electrode 143g of the second organic light-emitting element 140g, and the third cathode electrode 143b of the third organic light-emitting element 140b may be electrically connected to the pad electrode 181 in the non-display region NAA, respectively.

As illustrated in FIG. 3A, the first organic light-emitting layer 142r may be disposed separately in units of column lines along the first direction X, while being disposed to be continuously connected in a stripe shape along the second direction Y. Similarly, the second organic light-emitting layer 142g may be disposed separately in units of column lines along the first direction X, while being disposed to be continuously connected in a stripe shape along the second direction Y.

As illustrated in FIG. 3B, the pad electrode may comprise a lower pad electrode 181 and an upper pad electrode 182. The lower pad electrode 181 may be the same as the pad electrode 181 illustrated in FIG. 3a.

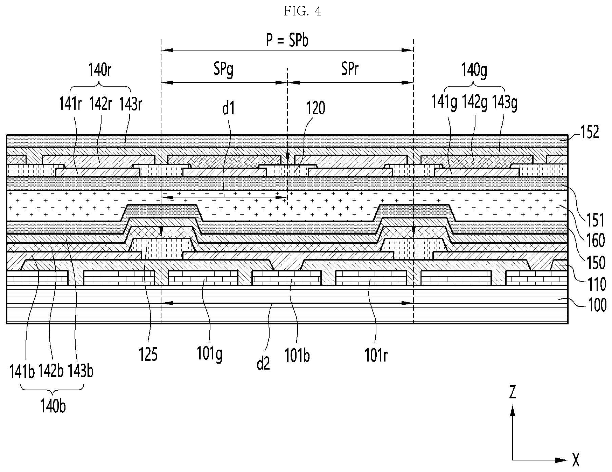

The upper pad electrode 182 may be disposed to extend from the lower pad electrode 181 onto the second inorganic insulating layer 151 in the non-display region NAA. The upper pad electrode 182 may be formed simultaneously with the third anode electrode 141b of the third organic light-emitting element 140b using the same patterning process with the same conductive material, but is not limited thereto. Accordingly, the upper pad electrode 182 may be disposed on an upper surface of the second inorganic insulating layer 151, similar to the third anode electrode 141b. FIG. 4 is a cross-sectional view illustrating an organic light-emitting display device according to a second embodiment. FIG. 4 is a cross-sectional view taken along line A-A' of the organic light-emitting display device of FIG. 1.

The second embodiment is similar to the first embodiment (FIG. 2) except that the third organic light-emitting element 140b is disposed under the first organic light-emitting element 140r and the second organic light-emitting element 140g. In the second embodiment, components having the same structure, shape, and/or function as those in the first embodiment are given the same drawing reference numerals, and detailed descriptions thereof will be omitted.

Referring to FIGS. 1 and 4, the organic light-emitting display device may comprise a substrate 100, a plurality of driving circuits 101r, 101g, and 101b, a protective layer 110, a plurality of banks 120 and 125, a plurality of organic light-emitting elements 140r, 140g, and 140b, a plurality of insulating layers 150 to 152 and 160, etc.

In an embodiment, the plurality of pixels P disposed on the substrate 100 may each comprise a first subpixel SPr, a second subpixel SPg, and a third subpixel SPb disposed three-dimensionally. The first subpixel SPr and the second subpixel SPg may be disposed to overlap each other horizontally. The third subpixel SPb may be disposed to overlap the first subpixel SPr and the second subpixel SPg vertically.

As described above, in the first embodiment (FIG. 2), the third subpixel SPb may be disposed in the first subpixel SPr and the second subpixel SPg. In contrast, in the second embodiment (FIG. 4), the third subpixel SPb may be disposed under the first subpixel SPr and the second subpixel SPg.

The first organic light-emitting element 140r may be disposed in the first subpixel SPr, the second organic light-emitting element 140g may be disposed in the second subpixel SPg, and the third organic light-emitting element 140b may be disposed in the third subpixel SPb.

Since the first subpixel SPr, the second subpixel SPg, and the third subpixel SPb are disposed three-dimensionally, the first organic light-emitting element 140r, the second organic light-emitting element 140g, and the third organic light-emitting element 140b may also be disposed three-dimensionally. The first organic light-emitting element 140r and the second organic light-emitting element 140g may be disposed to overlap each other horizontally. The third organic light-emitting element 140b may be disposed to overlap the first organic light-emitting element 140r and the second organic light-emitting element 140g vertically.

The third organic light-emitting element 140b may be disposed under the first organic light-emitting element 140r and the second organic light-emitting element 140g.

The third organic light-emitting element 140b may be disposed between the substrate 100 and the first inorganic insulating layer 150, and the first organic light-emitting element 140r and the second organic light-emitting element 140g may be disposed between the second inorganic insulating layer 151 and the third inorganic insulating layer 152. The organic insulating layer 160 may be disposed between the first inorganic insulating layer 150 and the second inorganic insulating layer 151.

Meanwhile, the first anode electrode 141r of the first organic light-emitting element 140r may be electrically connected to the first driving circuit 101r. The first anode electrode 141r may be electrically connected to the first driving circuit 101r through the plurality of insulating layers 150 to 152 and 160, the first bank 120, and the protective layer 110.

The second anode electrode 141g of the second organic light-emitting element 140g may be electrically connected to the second driving circuit 101g. The second anode electrode 141g may be electrically connected to the second driving circuit 101g through the plurality of insulating layers 150 to 152 and 160, the first bank 120, and the protective layer 110.

The third anode electrode 141b of the third organic light-emitting element 140b may be electrically connected to the third driving circuit 101b. Since the third anode electrode 141b and the third driving circuit 101b are disposed with the protective layer 110 interposed therebetween, the third anode electrode 141b may be electrically connected to the third driving circuit 101b through the protective layer 110.

Meanwhile, the third anode electrode 141b may comprise a reflective electrode, and the third cathode electrode 143b may comprise a transparent or translucent conductive film. The first anode electrode 141r and the second anode electrode 141g may comprise transparent conductive films, and the first cathode electrode 143r and the second cathode electrode 143g may comprise transparent or translucent conductive films.

In this instance, the first color light, the second color light, and the third color light are recycled between the first cathode electrode 143r and the third cathode electrode 143b, between the second cathode electrode 143g and the third cathode electrode 143b, and between the third anode electrode 141b and the third cathode electrode 143b, respectively, so that the light extraction efficiency can be improved.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

## Claims

1. An organic light-emitting display device, comprising:
a plurality of pixels on a substrate,
wherein the plurality of pixels each comprise a first subpixel, a second subpixel, and a third subpixel having a three-dimensional structure,
wherein the second subpixel is disposed to overlap horizontally with the first subpixel, the third subpixel is disposed to overlap vertically with the first subpixel and the second subpixel, and
wherein the first subpixel comprises a first organic light-emitting element, the second subpixel comprises a second organic light-emitting element, and the third subpixel comprises a third organic light-emitting element.

2. The organic light-emitting display device of claim 1, wherein the pixel has a same size as a size of the third subpixel.

3. The organic light-emitting display device of claim 1, wherein the pixel has a same size as a sum of a size of the first subpixel and a size of the second subpixel.

4. The organic light-emitting display device of claim 1, wherein the second organic light-emitting element is disposed to overlap horizontally with the first organic light-emitting element, and
wherein the third organic light-emitting element is disposed to overlap vertically with the first organic light-emitting element and the second organic light-emitting element.

5. The organic light-emitting display device of claim 1, wherein the first organic light-emitting element, the second organic light-emitting element, and the third organic light-emitting element each comprise an anode electrode, an organic light-emitting layer, and a cathode electrode, and
wherein the anode electrode is independently disposed in the first subpixel, the second subpixel, and the third subpixel, and the cathode electrode is commonly disposed in the first subpixel and the second subpixel.

6. The organic light-emitting display device of claim 5, wherein the first subpixel, the second subpixel, and the third subpixel each comprise an emission region and a non-emission region, and
wherein the emission region has a size corresponding to the anode electrode.

7. The organic light-emitting display device of claim 6, wherein a third anode electrode of the third organic light-emitting element is configured to vertically overlap a first anode electrode of the first organic light-emitting element and a second anode electrode of the second organic light-emitting element.

8. The organic light-emitting display device of claim 6, wherein a third anode electrode of the third organic light-emitting element has a size greater than a size of a first anode electrode of the first organic light-emitting element or a size of a second anode electrode of the second organic light-emitting element.

9. The organic light-emitting display device of claim 5, wherein the third subpixel is disposed in the first subpixel and the second subpixel.

10. The organic light-emitting display device of claim 9, wherein a first anode electrode of the first organic light-emitting element and a second anode electrode of the second organic light-emitting element each comprise a reflective metal,
wherein a first cathode electrode of the first organic light-emitting element and a second cathode electrode of the second organic light-emitting element each comprise a transparent or translucent conductive film,
wherein a third anode electrode of the third organic light-emitting element comprises a transparent conductive film, and
wherein a third cathode electrode of the third organic light-emitting element comprises a transparent or translucent conductive film.

11. The organic light-emitting display device of claim 5, wherein the third subpixel is disposed under the first subpixel and the second subpixel.

12. The organic light-emitting display device of claim 11, wherein a third anode electrode of the third organic light-emitting element comprises a reflective metal,
wherein a third cathode electrode of the third organic light-emitting element comprises a transparent or translucent conductive film,
wherein a first anode electrode of the first organic light-emitting element and a second anode electrode of the second organic light-emitting element each comprise a transparent conductive film, and
wherein a first cathode electrode of the first organic light-emitting element and a second cathode electrode of the second organic light-emitting element each comprise a transparent or translucent conductive film.

13. The organic light-emitting display device of claim 1, further comprising:
a plurality of insulating layers between the first organic light-emitting element and the third organic light-emitting element and between the second organic light-emitting element, and the third organic light-emitting element,
wherein the plurality of insulating layers each comprise at least one or more organic insulating layer and at least one or more inorganic insulating layer.

14. The organic light-emitting display device of claim 13, wherein a lowermost layer and an uppermost layer among the plurality of insulating layers are inorganic insulating layers.

15. The organic light-emitting display device of claim 1, further comprising:
a plurality of first banks between the plurality of first subpixels and the plurality of second subpixels; and
a plurality of second banks between the plurality of third subpixels.

16. The organic light-emitting display device of claim 15, wherein a second distance between the plurality of second banks is greater than a first distance between the plurality of first banks.

17. The organic light-emitting display device of claim 15, wherein a second distance between the plurality of second banks is equal to a width of the pixel or a width of the third subpixel.

18. The organic light-emitting display device of claim 1, wherein one of the first organic light-emitting element and the second organic light-emitting element comprises a red organic light-emitting element and the other comprises a green organic light-emitting element, and
wherein the third organic light-emitting element comprises a blue organic light-emitting element.
